# EUROPEAN PATENT SPECIFICATION

(11) **EP 1 412 964 B1**
(45) Date of publication and mention of the grant of the patent: **29.06.2011**
(21) Application number: 02727537.9
(22) Date of filing: 05.04.2002
(51) Int. Cl.: H01J 37/34, C23C 14/35

(54) **SPUTTERING MAGNETRON ARRANGEMENTS WITH ADJUSTABLE MAGNETIC FIELD STRENGTH**
EINRICHTUNGEN ZUM MAGNETRONZERSTÄUBEN MIT EINSTELLBARER STÄRKE DES MAGNETFELDES
DISPOSITIFS A MAGNETRON DE PULVERISATION PRESENTANT UNE FORCE DE CHAMP MAGNETIQUE REGLABLE

(30) Priority: 02.08.2001 GB 0118803
(43) Date of publication of application: 28.04.2004
(73) Proprietor: N.V. BEKAERT S.A., 8550 Zwevegem (BE)
(72) Inventor: DE BOSSCHER, Wilmert, Cyriel, Stefaan, B-9031 Drongen (BE); LAMMENS, Jean-Paul, B-9000 Gent (BE); BROCHE, Ronny, B-9840 De Pinte (BE); GOBIN, Guy, B-8400 Oostende (BE); BLONDEEL, Anja, G., J., B-9800 Deinze (BE)
(74) Representative: Bird, Ariane
(86) International application number: PCT/EP2002/003851
(87) International publication number: WO 2003/015124

(56) References cited:
- EP-A- 0 820 088
- EP-A- 0 858 095
- WO-A-00/38214
- WO-A-99/54911
- US-B1- 6 171 461
- PATENT ABSTRACTS OF JAPAN vol. 1996, no. 12, 26 December 1996 (1996-12-26) & JP 08 199354 A (ANERUBA KK), 6 August 1996 (1996-08-06)
- PATENT ABSTRACTS OF JAPAN vol. 016, no. 265 (C-0951), 16 June 1992 (1992-06-16) & JP 04 063274 A (MITSUBISHI KASEI CORP), 28 February 1992 (1992-02-28)
- PATENT ABSTRACTS OF JAPAN vol. 016, no. 020 (C-0902), 20 January 1992 (1992-01-20) & JP 03 236468 A (SHIN ETSU CHEM CO LTD), 22 October 1991 (1991-10-22)
- PATENT ABSTRACTS OF JAPAN vol. 012, no. 373 (C-534), 6 October 1988 (1988-10-06) & JP 63 125675 A (MATSUSHITA ELECTRIC IND CO LTD), 28 May 1988 (1988-05-28)

## Description

### FIELD OF THE INVENTION

This invention relates to sputtering magnetron arrangements and in particular to an apparatus and method for adjusting the magnetic output of a cylindrical sputtering magnetron so as to provide variable magnetic field strength in the region of a target surface.

### BACKGROUND TO THE INVENTION

It is known to provide techniques for releasing material from a sacrificial target and depositing it onto a receiving substrate as a film. One such technique is known in the art as sputter deposition and is particularly useful for depositing thin films, such as might be used during the manufacture of, for example, computer hard drives or memory devices or optical coatings onto glass.

During some known (non-magnetron) diode sputtering techniques, the target (a cathode) is bombarded by positive gas ions. The bombardment takes place in a vacuum chamber and, due to impacts between the ions and the target, neutral cathode atoms (i.e. sputtered particles) are released together with secondary electrons. After acceleration of the electrons in the cathode dark space, the high-energy electrons are mainly responsible for the creation of new ions by non-elastic collisions. They are ejected in all directions from the target and it is some of these particles which traverse the chamber and are deposited on the substrate to form the thin film.

This mechanism has several drawbacks which conspire to confine the physical geometry of the system and the range of sputter parameters. In addition, extensive substrate heating due to the impact of high-energy electrons is difficult to avoid, although it is known to provide cooling arrangements in an attempt to alleviate this particular problem.

The diode sputter deposition technique was improved during the 1970's by the introduction of permanent magnets directly behind the planar cathode. These magnets are arranged in such a way that magnetic field lines parallel and precisely in front of the cathode surface are obtained. The planar magnetron technology was further extended during the early 80's by the invention of the cylindrical magnetron. In this case, the cylindrical cathode tube rotates around a static magnet configuration, similar to the one used in planar magnetrons.

One type of magnetron arrangement is the planar magnetron, an example of which is disclosed in US4,818,358 in which an array of magnets is orientated to form two curved racetracks on a rectangular planar magnetron. Planar magnetrons are not limited to rectangular shapes and may also be circular, one such arrangement utilizing positionally fixed magnets being disclosed in US5,262,028.

A further planar magnetron is disclosed in WO 99/226274. In this application a planar magnetron is proposed in which a magnet assembly moves in relation to a target and can be conveniently considered to be a planar magnetron with moving magnets.

A further kind of magnetron is referred to as a cylindrical magnetron and one such arrangement is disclosed in WO 99/54911. In this case, the magnet assembly remains stationary while the target is in the form of a rotating cylinder.

In magnetron sputtering, electrons leaving the negatively charged target surface are submitted to an additional Lorentz force (result of a moving charged particle in a magnetic field) which forces them in a path along the target surface. As a consequence, these electrons stay available for ionizing collisions with gas atoms close to the target. This creates a denser plasma (more ionization), less loss of high-energy electrons and the ability to operate at lower pressures. All of these features produce a high efficiency sputter process with reduced drawbacks for the substrate and the geometry of the deposition system.

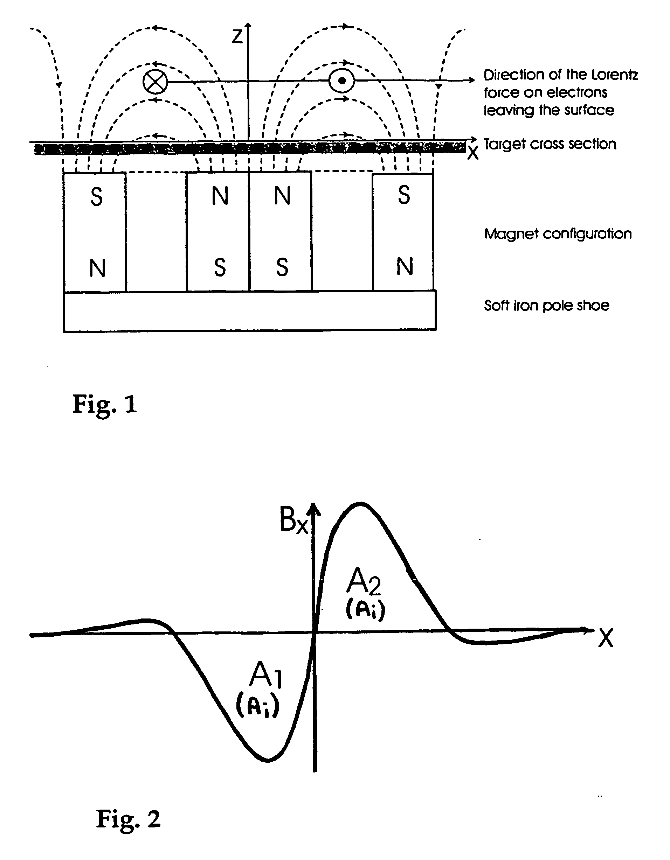

To make optimal use of this feature, it is important to create a closed loop magnetic field tunnel for which the magnetic field lines should be parallel with the target surface. A common embodiment of this principle is shown very schematically in fig. 1 with practical details of the field lines and direction of motion for the electrons.

Since the electrons leave the target perpendicular to its surface, i.e. along the z-axis, the Lorentz force is maximal for magnetic field lines which are lying in a plane perpendicular to the z-axis; i.e. the x-y plane. When evaluating the amplitude of the magnetic field vector in the x-y plane (labeled as Bₓ) along the x-axis for a fixed height on the z-axis, a curve as shown in fig. 2 is obtained.

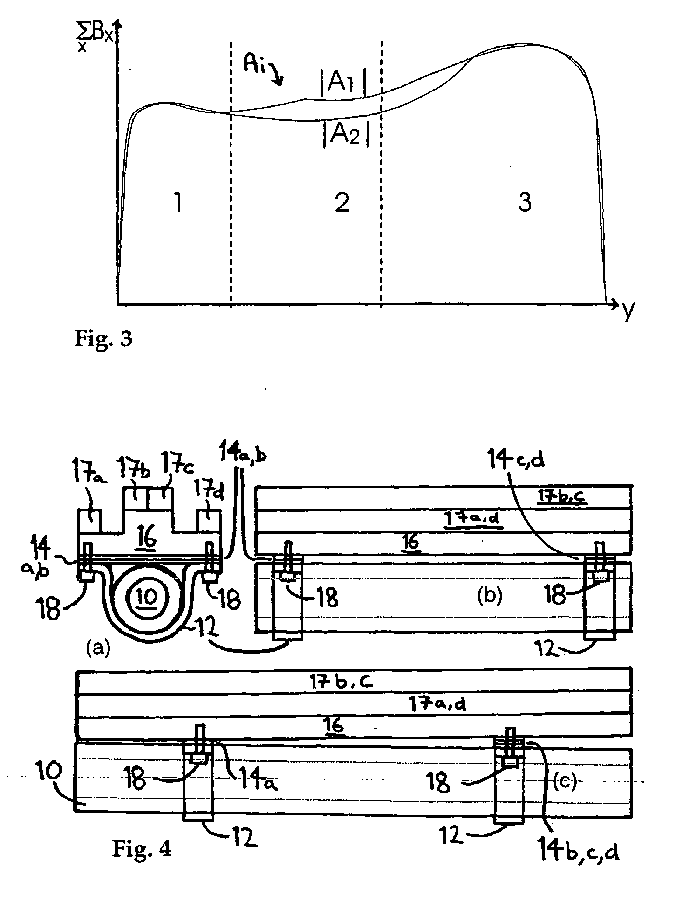

The smaller excursions at the extreme left and right in fig. 2 originate from field lines which close at the outside of the racetrack (see also outer field lines in fig. 1). The main excursion A₁ is formed by the outer left and central magnets in fig. 1 and is negative because the orientation of the magnetic field vector is opposite to the x-axis. Its absolute value becomes maximal close to halfway in between the magnets. It is exactly at this point that the field lines are parallel to the target surface. Between the central and outer right magnets, the Bₓ values are positive. The efficiency of the magnetron operation is defined by the magnetic bottling of the electrons for which the areas A₁ and A₂ are an indication. The areas A₁ and A₂ may for some purposes be considered as interchangeable, under which circumstances they are replaced for simplification of reference by the universal reference Ai. When used, Ai may be replaced by either or both of A₁ and A₂ as appropriate. Since the racetrack forms a closed loop magnetic field tunnel, uniformity of the Aᵢ areas is important. If at certain locations (e.g. in the turn of a race-track) the Aᵢ area is significantly smaller or bad shaped, electrons may be lost from the racetrack and ionization efficiency for the sputtering process may change significantly, e.g. an increase or a decrease. As a result, high uniformity of the Aᵢ areas along the y-axis (not shown in fig. 1 and 2) is essential for obtaining the maximal magnetron efficiency. If e.g. A₁ and A₂ are considerably smaller at a specific y-axis location, one may expect deviating sputter rates and local differences in coatings on the substrate. Fig. 3 depicts a possible non-uniform magnetic field strength area along the length of the target (i.e. y-axis).

In fig. 3, three different zones can be distinguished. Zone 1 depicts the ideal case were A₁ and A₂ are similar in area and relatively constant along the target length (not taking into account the zero value at its extremes, corresponding with a turn). In zone 2, the mean value of |A₁| + |A₂| is relative comparable with the sum in zone 1. As a result, the sputter yield in zone 1 and in zone 2 will be comparable for a moving substrate passing over both sputter zones Aᵢ. If, on the other hand, the substrate is stationary, we may expect a somewhat thicker layer for substrates located over area A₁ in comparison with area A₂ in zone 2. Since in most cases of large area coating, the substrate moves over the complete target, one did not pay attention to differences in opposite sections of the racetrack Aᵢ as long as the sum was constant. However, important changes in the sum |A₁| + |A₂| along the target length (i.e. zone 3) directly result in proportional changes to coating layer thickness. Nevertheless, although the sum |A1| + |A2| may be constant, strong opposite variations between |A1| and |A2| may result in loss of efficiency over the complete racetrack because of these local fluctuations.

Different techniques have been developed to adjust the magnetic field strength locally, leading to a different area or shape of Aᵢ:
a) A magnetic shunt, made of low magnetic resistance material may be placed underneath the target and interposed between the inner and outer magnetic poles, as a way to reduce local excess target erosion (US 4,964,968; US 5,174,880; US 5,415,754). In a particular case (US 5,685,959) the shunt is moveable in between the sputtering target and the source of magnetic flux. In JP 04-063274 A, the shunt is a magnetic fluid which can be deformed by a magnetic field.
b) The magnet arrangement includes a plurality of magnet segments which may be moved (WO 00/38214) or placed in holes (US 6,132,576) individually into desired positions as to change the shape of the magnet arrangement, as a way to achieve a more uniform erosion of the target (i.e. movement parallel to the target surface). JP 03-236468 A discloses movable magnet segments, annularly arranged around the target.
c) The magnet elements of the magnet assembly may have different spacing from the surface of the target to enhance deposition thickness uniformity (EP 0 858 095 A) (i.e. movement perpendicular to the target surface).
d) Each of the segment magnets is divided into upper and lower halves and the gap space held in between both halves is varied from position to position so that the uniformity of the magnetic field is increased with consequently increased uniformity of the plasma density (EP 0 661728 A1; EP 0 762 471 A1).
e) A plurality of magnets are individually mounted on iron bars with defined individual fixed length and have bores to receive magnetically conductive pins which may slide in- and outwards for varying the magnetic field distribution (US 5,079,481).
f) Use of an electromagnetic coil with a widely adjustable energizing current, rather than permanent magnets, allows a wide range of magnetic properties to be accommodated (US 4,500,409). A combination of several electromagnets with separate power control allows separate controlled discharges (US 4,595, 482). Permanent magnets may be combined with an electromagnet which is located behind the target (US 5,417,833) or even behind the substrate (US 5,439,574).
g) A magnet assembly consists of separate magnet plates, having magnets mounted thereon and at least two magnets plates (e.g. one corresponding to the inner magnets and one corresponding to the outer magnets) are moveable with respect to one another and operated by an actuator (US 5,980,707).
h) By adjusting the distance between the target and the magnet assembly, the magnetic flux density at the surface of the target may be adjusted with the purpose of maintaining largely constant sputtering conditions as the target plate is consumed (US 4,309,266; US 4,426,264). It is also known to adjust the magnetron-target distance by actuators (JP 08-199354 A).
i) By adjusting the distance between the magnetron (i.e. magnet assembly) or a portion of the magnetron and the sputtering target, improved film thickness uniformity is provided (EP 0 820 088 A).
j) Also known is the concept as shown in fig. 4 for rotating cylindrical magnetrons to adjust the spacing of the magnets locally relative to the target by adding or removing small shimming plates in between the central carrying tube (also bringing the cooling water to the end of the target tube before it flows back along the inner wall of the target tube) and the soft iron pole piece.

Disadvantages of prior techniques.
a) A magnetic shunt has shorting of the field lines in between magnets of opposite polarity as a main function. By doing this, the magnetic field strength above the target is decreased locally at the position of the magnetic shunt. Because of this, the optimal position of the magnetic shunt is just below the target (or below an intermediate cooling backing plate) and preferentially above the magnets. As a result, often some fixed space needs to be foreseen in between the magnet configuration and the backside of the target or cooling plate to allow the placement of magnetic shunts. However, this lowers the overall field strength above the target because the magnets are displaced further away from the target. Furthermore, by this technique only a decrease of magnetic field strength may be generated. If e.g. only a local dip in the overall magnetic field profile as shown in fig. 3 is observed, the complete remaining magnetic structure needs to be shunted to compensate for this local dip and a lower overall magnetic field strength (i.e. worse magnetic bottling effect) will be the final result. This is a solution for zone 2 problems and zone 3 problems if the field is locally too high but not too low (otherwise zone 1 and 2 have to be adjusted).
b), c), d) and e)
   Local displacement of individual magnets, magnet parts or soft iron parts are useful alternatives, however some mechanical limitations may inhibit adequate adjustments. A copper tube for conducting cooling water is often welded or brazed to the backside of the backing plate. The optimal location for these cooling channels is in between the magnets because this is the exact location where the heat is generated (i.e. location of plasma racetrack) and because the cooling tubes may not interfere with the magnets, which have to be as close as possible to the target. This means that a cooling channel often inhibits putting magnets of opposite polarity closer to each other. Placing the magnets of opposite polarity further away from each other is often very limited because of the compact construction of the magnet array within the magnetron housing. In smaller magnetrons, the problems with cooling water channels may be circumvented by designing a special cooling plate. However, the problem remains for large area magnetrons. A common alternative in large area magnetrons, is immersing the soft iron pole piece and all the magnets in the cooling water. However, corrosion is so heavy that the complete structure needs to be coated or painted to prevent instant degradation. Again, displacement of individual magnets in this case remains very difficult, because each time some recoating has to be performed to prevent water interaction. Separate coating of the magnets and the pole piece is a solution. After magnet displacement, still all pieces should be coated. But again, displacing magnets on a pole piece is very hard without damaging the coating. Because of the high magnetic forces, magnets may impact quite hard on the pole piece or on adjacent magnets, causing scratches and rupture of the coating and as a result local corrosion and degradation. This is a solution for fig. 3 type zone 2 and zone 3 problems, taking the remarks into account.
f) Using electromagnets is only feasible for smaller magnetron sizes and preferentially for circular magnetrons. It has an impact on the overall magnetic field strength and does not allow local changes. In addition, it complicates the magnetron concept and corresponds with an important price increase. This affects zone 1, zone 2 and zone 3 equally and does not offer a solution for local irregularities.
g) and h) Both are worthy alternatives to change the magnetic field strength. However, both have an impact on the overall strength and cannot be implemented to achieve a local change. This affects zone 1, zone 2 and zone 3 equally and does not offer a solution for local irregularities.
i) This configuration somehow extends the possibilities of g) and h) by allowing the straight magnet structure (e.g. a mathematical line) to move along a curved line. This set-up may be implemented successfully for the coating of stationary substrates in front of the target. The sputter yield in front of the 2D target will correspond with a smooth surface of which a cross section with a plane perpendicular to the direction of movement of the magnet structure will always be a straight line. Local bumps or dips remain impossible with this technique. This is no solution for zone 2 problems, but may provide in some simple cases a solution for zone 3 problems.
j) Referring in particular now to fig. 4, adding or removing shim plates 14a-d in between the bracket 12/water cooling tube 10 and the soft iron piece 16 may achieve local changes in the height of the magnetic structure. Practical implementation may however be quite difficult. If extreme differences are needed between maximum and minimum values of Aᵢ, one may not decrease the magnetic field by more than having no shims 14a-d, whereas one cannot increase the number of shims 14a-d too much because the magnets 17a-d would be touching the rotating target tube and block the rotation. Introducing additional or removing some shims 14a-d will require all brackets 12 to be loosened to be able to implement the change. If e.g. one wants to bring the magnets 17a-d locally 1 mm closer to the target, one may presume to introduce 2 shims 14a,b of 0.5 mm each at each end of the magnetron, as shown in fig.4(a), (b). However, depending on the current state of stress in the carrying tube, the tube itself may deform unexpectedly (as shown in fig 4 as well) resulting in an unsatisfactory adjustment which could only be noticed after reassembly, pumping down, sputtering and analyzing the uniformity. Furthermore, since we deal with a structure which is completely immersed in cooling water, every change brings along possible chances of degradation as discussed earlier. This is a solution for zone 3 problems only. Slightly turning a single bracket 12 over a small angle will result in sputtering sideways, but not in a different balance between the A₁ and the A₂ side (so does not solve the zone 2 problem) because this system is used inside a cylindrical target tube. If the target were planar, it would solve zone 2 problems as well.

Although the state-of-the-art does not offer a real solution for solving all different irregularities in a single adjustable magnetron system, even the perfect solution should have to cope with some additional challenges. Imagine that we were able to transform fig. 3 by adjustments into fig. 5. It is quite likely that a final customer might be quite unhappy with a super uniform magnetic field magnet bar. Introduction of a high uniformity magnetic system in a sputter coater running a complex reactive sputtering process, may result in a layer thickness profile as depicted in fig. 6.

There may be several reasons explaining why a uniform magnetic field results in a non-uniform layer thickness, especially during reactive sputter deposition processes:
- The vacuum pumping holes are not distributed equally over the width of the substrate but may be localized at both ends of the substrate
- The gas inlet distribution is not uniform. Especially reactive gases (i.e. oxygen or nitrogen) may react with the target material locally, creating local oxidation or nitriding with a much lower deposition rate as a consequence.
- Some anodes are more efficient than others and may shift denser plasmas to certain positions
- In an AC switching mode process between 2 magnetrons, there may be some electromagnetic interference between both magnetrons. If e.g. some electrons are lost in the turn of one cathode, they may be collected by the other magnetron acting as an anode.
- The general geometry of the coating zone may be such that plasma and gas flow is affected
- Some shielding may be present close to the magnetron or the substrate, influencing the amount of material arriving at the surface Some of these effects may be eliminated by a proper adjustment of the coating system. However, there is a high probability that a much better but still insufficient coating uniformity is achieved.

At present, optical coating stacks play an ever-increasing role in the large area coating industry. For example, solar control film allows reflecting the heat of the sun while being neutral visual transparent (i.e. equal amount of transmission for a wavelength region between 400 and 700 nm). These filter coatings operate on the principle of quarter wavelength layers with specific optical properties. Small differences in thickness may directly result in a shift of filter properties or in a non-neutral transmission within the visual region. Whereas coating stacks were much less critical 10 years ago and one could live with wide tolerances and non-uniformities of up to ± 5%, the well-designed stacks of today are much better performing but do not allow variations that exceed ± 1.5%. As a result, uniformity specifications of a magnetron concept within a specific vacuum coater should be able to meet the most stringent requirements.

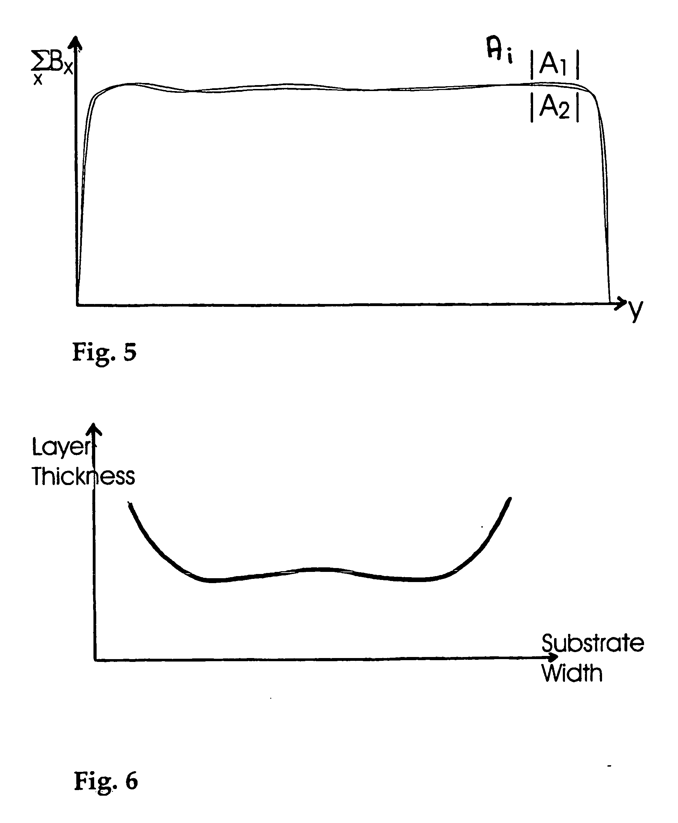

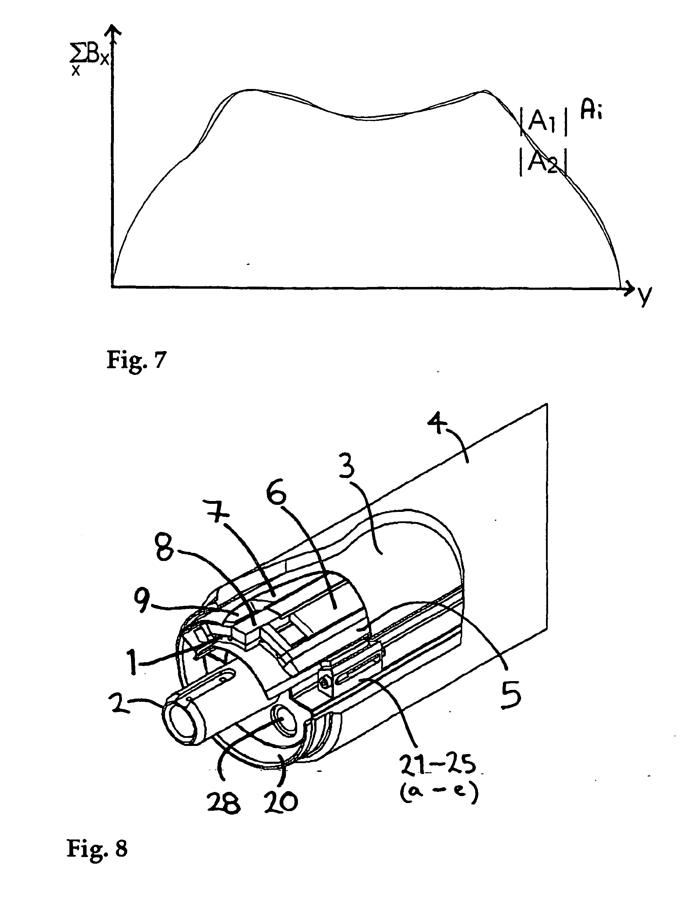

As a result, it is not sufficient to deliver a super uniform magnetron system, it should be able to be tuned in a fast and reliable way and be able to be precise within less than 1 percent. Furthermore, it should be able to cope with zone 2 non-uniformities to maximize magnetron efficiencies. In case of a fig. 6 result for a fig. 5 magnetic uniformity, it should be possible to tune to a fig. 7 magnetic profile to allow high uniformity of the deposited coating.

It is an object of the present invention to provide an improved magnetron arrangement.

### SUMMARY OF THE INVENTION

Accordingly, the present invention provides a cylindrical sputtering magnetron arrangement suitable for producing thin films as defined in claim 1. The arrangement comprising a magnetic field generator adjacent to a cylindrical target. Said magnetic field generator includes a magnetically active element and an adjusting means which is adapted to deform or deflect locally said magnetically active element so as to alter with respect to said target a position of at least a portion of said magnetic field generator. The magnetically active element may be rigid, e.g. may comprise a magnet array contained within a rigid housing.

Said deformation or deflection may be plastic or elastic and preferably reversibly so. Said deformation or deflection may be used to vary the magnetic field strength or the induction of a plasma racetrack across an eroding surface of said target. Said deformation or deflection may additionally or in the alternative be used to control the deposition thickness of a film onto a substrate.

Said adjusting means may comprise a series of force activating devices spaced apart along a separation line between a support structure and said magnetically active element, said deformation or deflection preferably comprising relative movement between said support structure and said magnetically active element in the region of one or more of said force activating devices.

Said force activating device may apply said deformation or deflection by mechanical application of a localized force, preferable a bending moment, to one or more predetermined portions of said magnetically active element. A plurality of said force activating devices may be used in combination to produce a predetermined deflection or deformation of said magnetically active element.

A said force activating device may comprise a pair of associated tuning members each defining a track-way, said track-ways running in different directions or planes to each other and yet guiding a common displacement element, so that movement of said displacement element in at least one direction along said track-ways causes relative movement between said members in such a manner that a said member is displaced away from the other said member. Said relative movement between said members may be used to perform said deflection or deformation of said magnetically active element. A first said tuning member may be restricted in its degrees of freedom by the other said member, preferably such that it can only move away from or towards said second tuning member in one plane which is the plane of application of a deflection or deformation force by said first tuning member to said magnetically active element.

Said adjusting means may further comprise an adjusting device adapted to move said displacement element along said track-ways. Said adjusting device may comprise a threaded adjuster which passes through a clearance hole along the longitudinal axis of a said tuning member and which is preferably captive, said displacement member including a threaded hole therethrough, through which said threaded adjuster is passed such that rotation of said adjuster causes translation of said displacement member along said track-ways and thereby converts said rotation into relative displacement between said tuning members.

Said adjusting means may further comprise means for providing feedback of the amount of said deformation or deflection applied to said magnetically active element. Said feedback means may comprise a scale which relates movement in said track-ways of said displacement element to displacement of one said tuning member in relation to another said tuning member, said scale preferably being user visible and more preferably comprising an indicator on said displacement member which is compared with a scale along a said tuning member.

Said adjusting means may be adapted to provide fine adjustment of a gap between said rigid element and said target. Said magnetic field generator may comprise a pole piece on which a magnet is located.

The magnetically active element comprises the housing surrounding a magnet array of said magnetic field generator. Said housing is substantially cooling water tight, such water tight integrity being maintained during and after a said deformation or deflection of said magnetically active element.

At least one of said housing or a support structure may include one or more topographical features adapted in use to conduct a flow of cooling water close to or over at least portion of said target and to generate in use a turbulence in said flow.

Said magnetic field generator may comprise an array of permanent magnets or electromagnets. Said magnetic field generator may induce a plasma racetrack in the region of a surface of said target, which racetrack is tunable by means of the application of said deformation or deflection.

Said magnetic field generator is included within the cylindrical magnetron.

Said magnetic field generator may be adapted to move in relation to said target or may be adapted to remain stationary with respect to said target.

Said deformation or deflection may be restricted to one or more portions of said magnetically active element, a further portion of said magnetically active element preferably being positionally fixed or adjustable by means of a substantially independent adjusting means. Said magnetically active element may include at least one feature of shape or configuration adapted to reduce rigidity or mechanical strength, such as segmentation, indentation, incision or a wrinkle zone, said feature being applied for example to a pole piece thereof.

The magnetic output of said magnetic field generator may be at least partially altered by means of side shunting. Said side shunting may be applied using stacking of one or several layers of metal tape/foil from e.g. 0.5 mm thick locally to the side of a magnetic array such as said magnetically active element. Said side shunting may realize local changes in the magnetic field strength of individual or groups of permanent magnets or may realize local changes in the integrated magnetic field strength for a bottling effect of electrons. Said side shunts may be adapted such that they do not extend over a top surface of their associated magnets and such that they magnetically short circuit magnetic field lines of opposite poles of the same magnet.

The present invention also provides a method of controlling a cylindrical sputtering magnetron, according to claim 16. The magnetically active element may be rigid, e.g. it may comprise a magnet array enclosed within a housing.

The method may include altering said position elastically or plastically, and preferably reversibly so. The method may include deforming or deflecting said magnetically active element so as to vary at least one of the magnetic field strength and the induction of a plasma racetrack across an eroding surface of said target.

The method may include generating said deformation or deflection by moving one tuning member, which is rigidly fixed to said magnetically active element, in relation to another tuning member which is rigidly fixed to a support structure of said magnetic field generator.

The method may include generating said relative movement between said tuning members by moving a displacement element simultaneously along a track-way of each said tuning member.

The method may include moving said displacement element by means of a lead screw arrangement.

The method may include performing fire adjustments, to a gap between said magnetic field generator and said target, so as to tune a plasma racetrack generated across the surface of said target or so as to tune the deposition of a film from said target on to a substrate.

### BRIEF DESCRIPTION OF THE DRAWINGS

The present invention will now be described by way of example only and with reference to the accompanying drawings.
Figure 1 is a schematic diagram of the principle of operation of a magnetron.
This is presented in the form of a cross section of a standard magnet configuration in a typical magnetron configuration, together with magnetic field lines, direction of drift for the electrons and a 3D coordinate system.
Figure 2 is a graphical representation of the magnetic field strength produced by an arrangement in accordance with Figure 1. Amplitude of the magnetic field strength parallel to the target surface Bₓ is illustrated as a function of the position along the x-axis.
Figure 3 is a graphical representation of integrated magnetic field strength produced across a target by an arrangement generally in accordance with Figure 1 but showing some lack of uniformity. Integrated magnetic field strength area parallel to the target surface |∑Bₓ| is shown as a function of the position along the y-axis.
Figure 4 shows a series of cross sections (a) to (c) through a variation to the arrangement of Figure 1. In Figure 4, (a) is a view in the x-z plane and (b) is a view in the y-z plane of; the central water carrying tube, brackets including 2 shimming plates per bracket, 2 bolts per bracket for attaching the soft iron pole piece and 4 magnet arrays. (c) is a view in the y-z plane of adjustment in which the left side gets a lower magnetic field on the target surface (1 shimming plate) and the right side gets a higher field (3 shimming plates).
Figure 5 is a graphical representation across a target surface of a theoretically ideal integrated magnetic field. Integrated magnetic field strength area parallel to the target surface |∑Bₓ| is illustrated as a function of the position along the y-axis and with an adjustable magnetic structure to compensate the irregularities of Figure 3.
Figure 6 is a graphical representation of the possible relative thickness across a deposition layer resulting from the application of a magnetic field according to
Figure 5. Relative layer thickness across the width of a large area substrate while using a magnetron with high uniformity magnetic strength is illustrated.
Figure 7 is a graphical representation of the required optimal integrated magnetic field across a target surface in order to compensate the results of
Figure 6 so as to achieve a relative thickness across a deposition layer with high uniformity. Integrated magnetic field strength area parallel to the target surface |∑Bₓ| is illustrated as a function of the position along the y-axis and with an adjustable magnetic structure to compensate for non-uniform layer deposition.
Figure 8 is an isometric cut-away of a cylindrical magnetron assembly according to one embodiment of the present invention. The view comprises an isometric cut-away view of an adjustable magnet bar assembly, mounted within a cylindrical target tube.

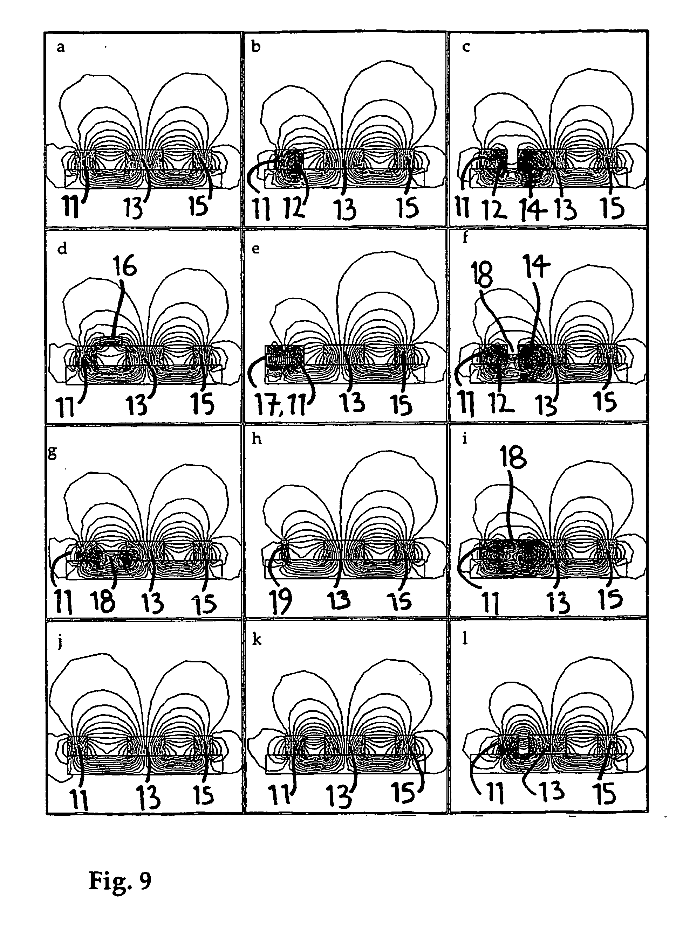

Figure 9 is a series of thumbnail graphical representations of various magnet configurations. Magnetic field line distribution is illustrated for a cross section of various magnet configurations in a magnetron in which the field lines are scaled at 5 mWb/m.

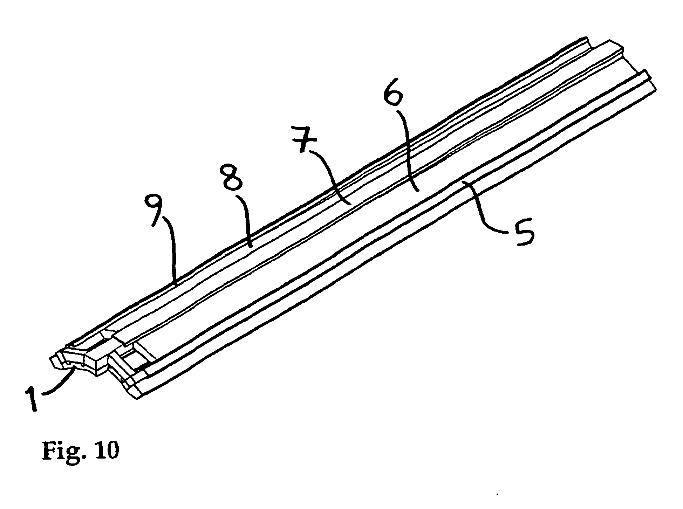

Figure 10 is an isometric view of magnetic side-shunting on a curved iron pole-piece useable in the embodiment shown with respect to Figure 8. This is an example of practical implementation of magnetic side shunting on a curved soft iron pole piece for utilization in a cylindrical magnetron. Bottom left has maximal side shunting, corresponding to case 9.i, while the shunt changes in shape to finish up with no shunting at all at the top right location of the magnet bar.

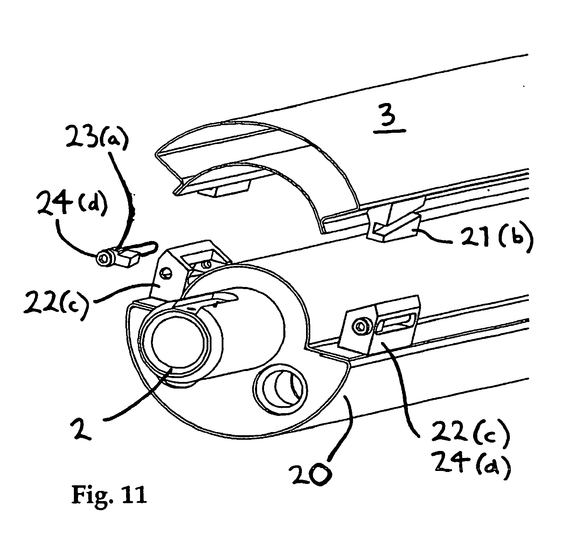

Figure 11 is an exploded view of part of the structure of the cylindrical magnetron of Figure 8, the pole piece of Figure 10 not being shown in this view. The view shows the magnet bar system, containing the magnet housing, the supporting structure and the intermediate tuning system.

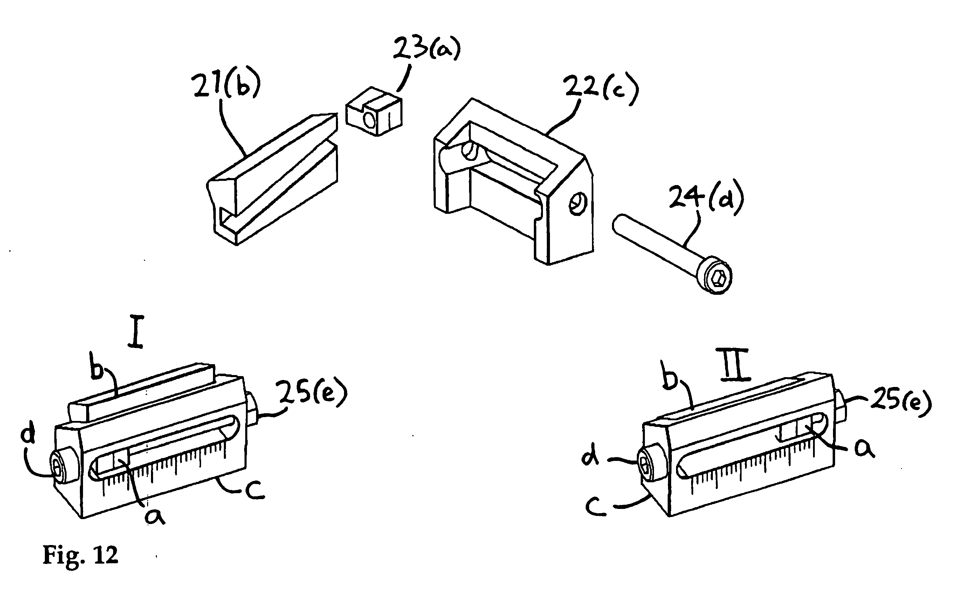

Figure 12 is an exploded view of a magnetron fine tuning/adjustment arrangement in the form of a force activating device according to the embodiment shown with respect to Figures 8, 10 and 11. The extreme settings are shown on bottom left (maximum expansion) and bottom right (minimum expansion).

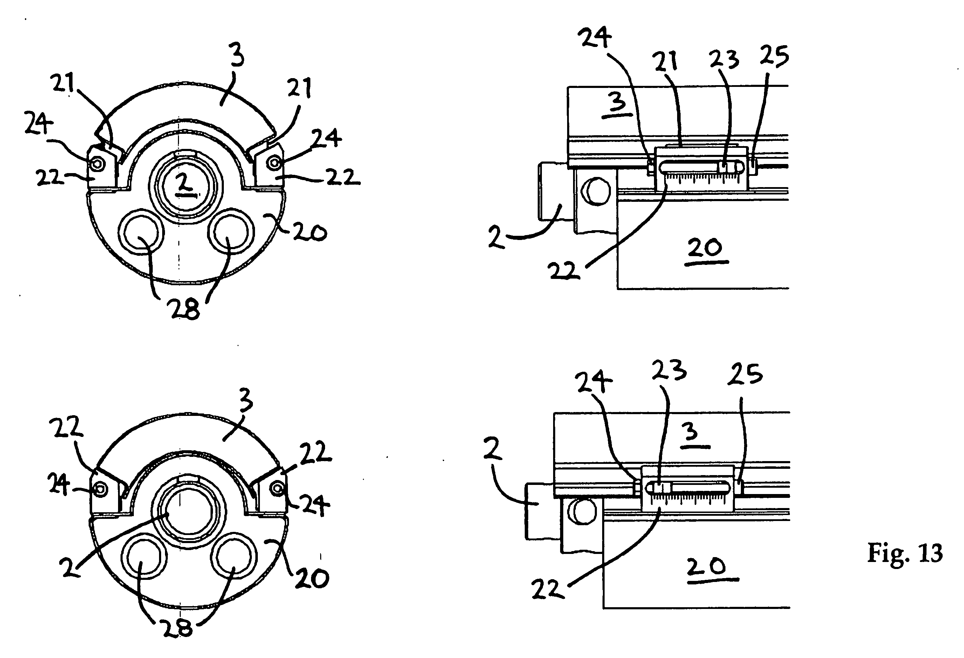

Figure 13 comprises top and side views in two configurations of an assembled cylindrical magnetron arrangement according to the embodiment of Figures 8 and 10 to 12.

### DETAILED DESCRIPTION OF PREFERRED EMBODIMENTS

Referring to the figures, the present invention will be described with respect to certain drawings and a particular embodiment, which comprises a cylindrical magnetron arrangement. It will be understood, however, that the scope of the present invention is not so limited and that various modifications and equivalent structures/methods can be envisaged which do not depart from the nature of the inventive contribution to the art.

Referring now briefly in particular to Figures 8 and 10 to 13, a cylindrical magnetron comprises arrangements for adjusting the local position of the magnetron's magnetic filed generator, e.g. an magnet array, with respect to the target in order to tune the operation of the magnetron. For example, it is possible to modulate the erosion rate of the target locally or to modulate the rate of deposition onto a substrate, e.g. to provide substantially equal erosion of the target and/or equal deposition of film on an associated substrate. The tuning is performed by deflecting or deforming the magnet array such that the strength of its magnetic field across the target is locally variable, as will be described in more detail below.

The magnetron magnetic field generator may have two separate systems for adjusting the magnetic field strength, each of which may be used independently of the other. The rough system is tuned during construction of the magnetic field generator while taking into account the influence of the vacuum system (e.g. geometry, gas flow, anodes, etc.). The influence of the system may be defined by introducing a magnetic field generator such as a uniform magnet bar (i.e. as shown in fig. 5) and measuring the layer thickness on the substrate as produced by this specific magnet bar (i.e. as shown in fig. 6). Whenever the layer thickness profile lies well within ± 10%, i.e. less than 20% peak to peak, one may consider leaving out the rough tuning and achieve a very uniform thickness profile only by adjusting the fine-tuning system.

However, when a clear V or Λ shape or W or M shape thickness profile is observed on a substrate when using very uniform magnet bars, doing a rough adjustment is advised. In this case, the exchangeability of the rough tuned magnet bars to all the deposition slots is guaranteed while fine-tuning can still be done on the spot. The user is not able to adjust the rough tuning settings, while adjustment of the fine tuning system can be made very quickly, very accurately and in a user-friendly manner. Furthermore, the fine tuning settings may be read on a scale, noted down and used later on as a reference for new experiments or production settings.

Returning to the rough tuning system, the cross section of a typical magnet bar system is shown in fig. 1 as discussed above. The proposed solutions for adjusting the magnetic field in zone A₁ and zone A₂ separately are depicted in fig. 9 for the case of a planar magnetron. In all examples, zone A₂ is left untouched while only zone A₁ is adjusted to see the effect more easily.
a) This case is the neutral and symmetric reference set-up, corresponding with fig.1, in which both A₁ and A₂ zones are equal
b) In this case the left outer magnet 11 has a side shunt 12 of half magnet thickness attached to this magnet at the inner side thereof (towards the central magnet 13); all the field lines leaving the right half side of the left magnet 11 are shunted and only the field lines leaving the left half side of the left magnet are able to reach the central magnet 13. This situation is in fact comparable with a left magnet of half width, located at the left half of the left magnet. The A₁ is decreased rather uniformly while the A₂ zone is slightly increased. More than half of the central magnet 13 is now participating in the formation of the A₂ zone. As a result, this technique of side shunting is very effective in a uniform overall reducing of an Aᵢ zone, while slightly increasing the opposite zone.
c) In this case, case b) is further extended with a similar side shunt 14 attached to the A₁ side of the central magnet 13, i.e. towards magnet 11. This does not change the relative magnitude of the A₁ to the A₂ side as observed in the b) case, though it creates an overall decrease of the magnetic strength. Indeed, now the central magnet 13 is weakened as well (its left side is shorted by the shunt) and still delivers a smaller part to the A₁ zone for the virtual smaller outer left magnet and a larger part to the A₂ zone because of the original outer right magnet 15.
d) The use of shunts has already been discussed in the introduction to this application. The magnetic field line distribution confirms that a magnetic shunt 16 in between 2 magnets 11, 13 and located partly higher than the top surface of the magnetic source shortens the field from opposite poles of different magnets; i.e. the outer and central magnet 11, 13. Furthermore, as described in the claims of related patents to this approach, this configuration decreased the magnetic field strength locally (as can be seen by the lower density of field lines just above the shunt in fig. 9.d) to compensate for excess erosion at that specific location. Drawing fig. 2 just above the shunt 16 should correspond with a flattened minimum in zone A₁ to create a larger region of uniform field and, as a consequence, of uniform erosion by slightly eliminating the deepest point of the erosion groove. It is clear that embodiment 9.d is different from e.g. embodiment 9.b, 9.c, 9.e, 9.f, 9.g and 9.i because the magnetic shunt 16 in 9.d is partly located above the top surface of the magnetic source (e.g. permanent magnets in this case) and is primarily intended to short field lines of opposite poles of different magnets. In contrast, the side shunts never exceed the top surface of the magnetic means and are primarily intended to short field lines of opposite poles of the same magnet. As a consequence 9.d is primarily intended to deform the shape of the Aᵢ region and trying to eliminate the peaks while maintaining its area, while the side shunts are primarily focused on an overall decrease of the Aᵢ area.
e) This case is a further extension of 9.b with a similar shunt 17 attached also to the left side of the left outer magnet 11. Now most of the field lines leaving the left side of the left magnet are shunted by the left side shunt, while most of the field lines leaving the right side of the left magnet are shunted by the right side shunt. Only a slight portion of the central field lines of the left magnet is able to reach the central magnet 13. This situation is in fact comparable with a left magnet of about quarter width, located central with respect to the original left magnet. The A₁ is decreased rather uniformly while the A₂ zone is slightly increased. More than half of the central magnet is now participating in the formation of the A₂ zone. As a result, this technique of double side shunting is extremely effective in a uniform overall reducing of an Aᵢ zone, while slightly increasing the opposite zone. In fact, 9.h shows a left magnet with a size of 40% with respect to the original left magnet and at its exact location. The form of the field line distribution is comparable with the 9.e case, though the 40% width magnet of case 9.h is still considerable stronger than the double shunted original magnet of 9.e.
f) This case attaches a base shunt 18 in case 9.c. As can be seen, the effect is so small that it can be neglected. This teaches that a base shunt 18 has a minimal effect.
g) In this case, starting from the reference 9.a, only a base shunt 18 of half magnet height is introduced in between the outer left and the central magnet 11, 13. The form of the magnetic field line distribution is not significantly changed, although a slight decrease in strength is observed. This means that the shape of the A₁ zone remains practically unchanged while its area decreases slightly. Small changes of the height of the base shunt (while remaining less than half of the total magnet height) have minimal effect on the Aᵢ zone.
h) See explanation for the 9.e case in which a quarter width left hand magnet 19 is described.
i) This case is a further extension of 9.g where the height of the base shunt 18 is further increased, while keeping it below the height of the magnets. As could be expected, the behavior is quite similar to the 9.c case where the field lines leaving the right side of the left magnet are shunted and the field lines leaving the left side of the central magnet are shunted as well. The explanation of c) is valid here. However it is interesting to see that the influence of a base shunt increases more rapidly when it is higher than half the magnet height. So, the base shunt is very accurate for small changes when it is low, while its effect gets much larger when it is high.
j) In this case, starting from the reference 9.a, the outer left magnet 11 is displaced further away from the central magnet 13. Although the effects of this case bear some resemblance to some of the prior art disclosures discussed in the introduction (e.g. in "b"), there is a definite difference. The displacement of magnets as described in these patents is purely intended to displace the racetrack and, as a consequence, generate a better erosion of the target. In this case however, the width of the racetrack and the shape of zone Aᵢ is changed to influence the sputter yield locally. If the magnets are further apart, the shape of zone Aᵢ will get wider and the area will increase up to a certain point of maximal efficiency. If the magnets are spaced further apart, the zone will get wider but the field strength will go down below the point of optimal magnetic bottling.
k) and l) The outer left magnet 11 is now displaced closer to the central magnet 13 when compared with the distance between the central magnet 13 and the right outer magnet 15. One may expect that the magnetic field strength will be much higher locally (i.e. sharp peak in the Aᵢ curve), though the overall area will go down, the magnetic field will weaken and lower sputter yield will be the result. One may go up to the point where the outer left magnet is attached to the central magnet 13, resulting in a very low overall magnetic field strength.

Although, the techniques of side shunting and displacing individual magnets are both very powerful in realizing local adjustments of the magnetic field strength, side shunting is the most practical. In this case, the magnets are always placed in substantially the same position, and adjustments are implemented by placing soft iron pieces of the correct shape attached to a single outer or inner magnet or placed in between the magnets, but below the top surface of the magnets.

The magnetic output of the magnetic field generator may be at least partially altered by means of the side shunting, applied for example using stacking of one or several layers of metal tape e.g. from 0.5 mm thick and locally to the side of a magnetic array which forms part of a magnetically active element. The side shunting may realize local changes in the magnetic field strength of individual or groups of permanent magnets forming the magnetically active element or may realize local changes in the integrated magnetic field strength for a bottling effect of electrons. Furthermore, the side shunts may be adapted such that they do not extend over a top surface of their associated magnets and such that they magnetically short circuit magnetic field lines of opposite poles of the same magnet within the magnet array.

Staying below the top surface of all magnets forming the magnetic array has the additional advantage that the magnets are always in their closest position to the target and always fit in the same housing, independent of the amount of shunting that is performed.

A practical implementation of the shunting (6, 8) can be seen in fig. 10 in the form of a magnetically active element that in this embodiment comprises a magnet array 1 and a housing 3. Two outer magnet arrays 5, 9 flank a central magnet array 7. Shunts 8 and 6 are located between magnet array pairs 7, 9 and 5, 7 respectively. The depth of the shunts 6, 8 vary along the length of the magnet assembly 5, 7, 9. Depending on the result of fig. 6, the shape of the side shunt can change gradually to accommodate the required adjustments.

A fine-tuning system in accordance with the present invention may be employed independently of the chosen rough tuning technique. This fine tuning mechanism is embodied in the form of one or more force activating devices adapted to deform or deflect the magnetically active element. Such force acting elements are depicted in Figure 12 and shown in place in Fig. 11. The or each force activating device (21-25; a-e) is adapted to implement such distortion/deflection in such a manner as to vary the distance between a part of the magnetically active element and the target 4. This varies the magnetic field strength in the region of an eroding portion of the target 4 and is used to control at least one of deposition thickness of the layer being deposited from that target 4 and localized rates of erosion of the target 4. As can be understood, a magnetically active element formed only of the magnet array 1as assembled and partly shown in fig. 10 is open to attack by water and consequent corrosion. To prevent this, the magnet structure 1 (from fig. 10) is preferably mounted in a closed water resistant housing 3, e.g. a stainless steel cabinet that is closed by welding. The housing 3 is preferably rigid or composed of rigid sections, e.g. self-supporting. A magnet housing structure 3, a supporting structure 20 and fine tuning mechanism 21-25 is depicted in fig. 11, while the tuning mechanism 21-25 itself is depicted in exploded form in fig. 12 and the complete assembly in fig. 8. The tuned magnet system of fig. 10, slides into the magnet housing 3 (depicted in the top of fig. 11) to form the magnetically active element and is thus rigidly encased in this housing 3. After that, two moon shaped end capping parts close both ends of the magnet housing 3 hermetically and prevent any further interaction with the environment, e.g. cooling fluid. It will be understood that further rough tuning becomes impossible without breaking the seals of the magnet housing 3.

At a fixed spacing along the length of each side of the magnet housing 3, a tuning part in the form of an inner block 21 ("b" in fig. 12) is provided which defines a groove sloping with respect to the longitudinal axis of the magnet housing 3. The blocks 21 are rigidly attached to their respective sides of the magnet housing 3 at substantially equal distances along the edges of a separation line between the support structure 20 and the housing 3.

The central supporting and water conducting tube 2 is extended with a structure containing internal reinforcements. The outer casing of the support structure 20 is of a generally cylindrical shape and has an outer diameter that is a few millimeters smaller than the inner diameter of a surrounding target tube 4. The additional reinforcements of the supporting structure 20 have a double function:
- Limit catenary bending on long magnet bars to an absolute minimum. These forces may occur due to gravity or due to other forces during processing (e.g. upward force when suspended in water)
- Improve rigidity of the complete supporting structure so that a local compressive or tensile force between the magnet housing 3 and the supporting structure may be completely translated to a relatively local deformation of the magnet housing 3 while the supporting structure 20 remains substantially unchanged.

Consequently, the supporting structure 20 is preferably filled with low mass hardening foam material through the holes 28 at both ends. Finally, those holes 28 are closed as well.

Views of a particular but non-limiting structural form of the tuning mechanism parts 21-25 is shown in more detail in fig. 12. At both sides of the supporting structure 20 and at a fixed spacing along the length of the magnet housing (exactly corresponding with the parts 21 attached to the magnet housing 3), further parts of the tuning mechanism 21-25 in the form of an outer block 22 ("c" in fig. 12) are attached. The outer blocks 22 each define a groove which is parallel with respect to the longitudinal axis of the magnet housing 3. The now closed magnet housing 3 and now foam-filled and closed supporting structure 20 are connected to each other through the fixed tuning parts 21, 22 by introducing a slideable wedge 23 ("a" in fig. 12) and a lead screw in the form of an adjuster bolt 24 ("d" in fig. 12).The tuning part (c) 22 which is attached to the supporting structure 20 has a straight groove, which extends through the complete piece. The slideable wedge (a) 23 contains a sloped spline that fits in the groove of (b) 21 and a straight spline (with respect to the axis of the threaded hole) that fits in the groove of (c) 22. The slideable wedge (a) 23 has a reference mark on an outward facing side of the spline which fits in the groove of the outer block (c) 22 and has a threaded hole corresponding with the thread of the bolt (d) 24. In one example, the angle of the sloped groove defined by the inner block (b) 21 is relatively small, preferably lower than 15°.

After mounting the magnet housing 3 on the support structure 20 and fitting part (b) within the forked ends of part (c), the wedge (a) is introduced through the outer opening of part (c) after which the bolt (d) is mounted through a non-threaded clearance hole of part (c) and screwed in to the wedge (a). After threading mounting bolt (d) completely through part (c), a small screw (e) 25 is fixed, e.g. by welding, to the other side of the bolt 24, preventing the bolt 24 from being removed.

If the system is in its most extended position (I in fig. 12), one has to turn the bolt 24 counter clockwise to move the wedge 23 to the other side, during which part (b) will slightly move down within part (c). At the same time, movement of part (b) will result in localized downward movement of the magnet housing 3, while the screw (e) will prevent the bolt (b) from being turned out of part (c).

When the tuning system is in its most compact position (II in fig. 12), turning the bolt 24 clockwise will move the wedge 23 to the other side, during which part (b) is pushed upwards out of part (c). At the same time, part (b) will push up the magnet housing 3 locally and will deflect/deform the magnet housing 3 upwardly while the head of the bolt (d) 24 will exert a force against part (c). Because the angle of the slope in part (b) is relatively small, a large displacement of the wedge 23 (a) will correspond with only a small upwards displacement of part (b) relative to part (c). This large reduction factor is important for several reasons:
- It allows a very accurate positioning of part (b), within part (c)
- It reduces the enormous forces to deform the magnet housing to an easily adjustable bolt which is far off being stressed to its maximum torque level

An additional functionality can be added by applying a scale to part (c) and using the reference mark on the wedge (a). A sub millimeter accuracy can easily be attained on this scale and may even be combined with the angular position of the bolt (d). As a result, one may easily check a certain position, may know how much one has to add or subtract to obtain another condition and even note down the absolute value corresponding with a specific setting. In one exemplary practical implementation, the angle of the sloped groove is 5.73° and the total range of the wedge is 50 mm. The bolt is of the type M5 and has a pitch of .8 mm per turn. Due to the slope of 5.73°, moving the wedge over about 40 mm corresponds with moving part (b) vertically with respect to part (c) over about 4 mm. Imagine that we take as best accuracy in regulating the system, turning the bolt over 90°, which corresponds with a movement of the wedge (a) of 0.2 mm and of part (b) of 20 µm. We may assume that a relative movement of part (b) with respect to part (c) is translated to a movement of the magnet housing 3 and therefore also of the magnet array 1 encased therein, but not of the supporting structure 20 because of the rigidity of the latter as a result of its construction.

Experiments have shown that moving the magnet array 1 in the magnetically active element 1 mm with respect to the target surface 4 by deformation or deflection corresponds with a change in magnetic field strength of 5%. Since the magnets may be moved at least over a range of 4 mm (peak to peak) with the above fine tuning mechanism, the magnetic field strength can be adjusted in the order of 20%. In a specific case, a pre-tuned non-uniform magnet bar with well-defined zones of various magnetic field strength was compared with its resulting layer thickness uniformity (i.e. a fig. 6 type of comparison). In this case, a linear relationship was found between layer thickness and magnetic field strength and the slope factor was close to 1. As a result in this specific case, a change of magnetic field strength of e.g. 5% corresponds with a proportional change of layer thickness of about 5% as well.

Considering the accuracy which can be achieved with the above fine tuning system and using the figures given in the example above: Turning the bolt over 90° results in a displacement of the magnets of 20 µm, which in turn corresponds to a change of magnetic field strength of 0.1% and in some cases corresponding to a change in layer uniformity of 0.1%. Since tolerances are preferably between ± 5% (i.e. 10% peak to peak) to ± 1.5% (i.e. 3% peak to peak), a fine-tuning system in accordance with the embodiments of the present invention is more than accurate enough to cope with these requirements.

In a real life configuration, several tuning conditions may be used (fig. 13 shows the extreme settings in which the gap 29 is either completely closed or completely open). Regulating opposite tuning sets separately (i.e. left and right sets in top view of fig. 13) allows settling zone 2 problems in fig. 3. Adjusting opposite tuning sets equally allows solving zone 3 problems in which both increase and decrease of magnetic field strength may be obtained. Adjustment of an individual tuning set does not pose any problem. The complete length of the part (b) attached to the magnet housing is somewhat smaller than the recess in part (c) forks used to accept part (b). As a result, adjusting a single tuning set will allow neighboring sets to slightly move sideward without exerting a sideways force between part (b) and part (c). In addition, the small play that part (b) has within part (c) allows for some pivoting if neighboring fine tuning sets are adjusted in opposite ways.

The amount of fine tuning sets needed to accommodate most situations depends on the length of the magnet bar and the accuracy needed over the width of the substrate. However, some guidelines may be applied. The minimal number of opposite sets is at least 1 more than the length of the magnet bar in meter. If the magnet bar is e.g. 1,5 m long, than 3 opposite sets (i.e. 6 sets in total) is the recommended minimum because of mechanical robustness of the system. Large magnet bars of more than 3.5 m long should need 5 opposite sets at least. Having only 2 sets (e.g. for a magnet bar of 50 cm) at the extremes only allows the introduction of linear gradual changes across the substrate width. The more sets used, the more complex shape can be established. However, going to more than 5 sets needs careful consideration as to whether it's really needed. Fig. 6 already shows a quite complex situation which can in fact be regulated by only 5 sets. The most common V or Λ shaped non-uniformities can be solved by only 3 opposite sets. However, W or M shapes can only be adjusted by a 5 set configuration. In practice, the regulation can be compared by drawing a fluent line through a number of points (corresponding with the number of opposite fine tuning sets) according to a Bezier curve or spline algorithm.

It is believed that the proposed adjustable magnet bar system has some important advantages over the existing state-of-the-art solutions.
• The solution as claimed is applied to magnetrons of the cylindrical type
• The magnetic field strength can be adjusted quite accurately by using side shunts, which are located next to and preferably not higher than the magnetic sources (e.g. permanent magnets)
• The magnetic field strength can be adjusted quite accurately by displacing magnets of one polarity relative to magnets of the opposite polarity
• The degree of fine-tuning of the uniformity of magnetic field strength that can be achieved by the proposed concept is extremely high, is absolute and can be quantized quite easily by reading a scale
• The degree of fine-tuning of the uniformity of the sputter yield that can be achieved by the proposed concept is extremely high, is absolute and can be quantized quite easily by reading a scale
• The degree of fine-tuning of the uniformity of the sputter deposited layer thickness that can be achieved by the proposed concept is extremely high, is absolute and can be quantized quite easily by reading a scale
• The magnets are not immersed in water and as a consequence are not prone to corrosion
• Tuning the -magnetic field strength does not challenge the corrosion resistance integrity and can be done at any desired moment
• Tuning of a single side of a racetrack is possible, allowing optimizing the magnetron efficiency
• The magnet bar housing forces the cooling water close to the target tube, resulting in an optimized heat transfer and cooling efficiency
• The magnet bar outer housing may be provided with a topography to enhance turbulent water flow, which further enhances cooling efficiency
• A method is provided for changing the distance between the target surface and the magnetic means by a controlled mechanical deformation of a part of the magnetic means
• A system is provided for translating a rotational movement to a perpendicular transverse movement, combined with an accurate readout of the transverse movement by a linear scale perpendicular to this movement.

The proposed adjustable magnet configuration can also be applied to:
- Rough tuning to obtain a uniform and homogeneous magnetic field strength over a substantial part of the target surface
- Fine tuning to obtain a uniform and homogeneous magnetic field strength over a substantial part of the target surface
- Rough tuning to obtain a uniform and homogeneous erosion over a substantial part of the target surface
- Fine tuning to obtain a uniform and homogeneous erosion over a substantial part of the target surface
- Rough tuning to obtain a uniform and homogeneous deposited layer thickness by sputter deposition over a substantial part of the substrate width
- Fine tuning to obtain a uniform and homogeneous deposited layer thickness by sputter deposition over a substantial part of the substrate width

The present invention offers a larger flexibility in possible magnet adjustments for magnetron sputtering, together with a very high accuracy and user friendliness for adjusting the magnetic field strength.

Zone 2 and zone 3 irregularities may be adjusted individually. Very high differences in magnetic field strength may be achieved, while very high absolute magnetic field strengths may be achieved as well. In comparison to existing commercially available magnet configurations for exactly the same application (e.g. as depicted in fig. 4 and in neutral position), the neutral magnetic field strength of the new invention is about 60% higher.

The skilled person will appreciate that an adjustable magnet field generator in accordance with the present invention contains at least one of two systems for adjusting the magnetic field strength. A first system is intended for rough adjustments and should preferably only be performed to compensate the irregularities which are generated by the geometry and/or gas flow of a specific vacuum coater system. With this system, the magnetic field strength can be adjusted locally, for instance within + 0% and - 40%. Even in the worst compensation, the magnetic field strength remains large enough to sustain the magnetic bottling and is in fact comparable with the neutral position of the commercially available magnet system. The exact location of side shunts, on the outer or inner magnets and on the left or right ride of the magnets, may play an important role in sustaining the required bottling of electrons.

A second adjustment system is intended for fine adjustments which are needed to achieve the final few percentages of uniformity. With this system, a local adjustment of + 10% and - 10% may be regulated with an accuracy of about 0.1% uniformity in magnetic field strength. Both adjustment systems work on either or both A₁ and/or A₂ areas.

The plastic and/or elastic deformation/deflection of the magnet structure and/or supporting structure is well controlled. Elastic deformation can occur for the fine-tuning system and in this case the total amount of deformation is rather limited because the focus is on minute adjustments. Furthermore, the supporting structure is relatively large and internally reinforced to achieve a rigid structure which does not bend when the magnet structure is adjusted. As a result, fine tuning adjustments are absolute.

It will also be appreciated that the deformation or deflection of the magnetically active element may be restricted to one or more portions of the magnetically active element. A further portion of the magnetically active element is preferably positionally fixed or adjustable by means of a substantially independent adjusting mean. The magnetically active element may include at least one feature of shape or configuration adapted to reduce rigidity or mechanical strength, such as segmentation, indentation, incision or a wrinkle zone, said feature being applied for example to a pole piece thereof.

In this invention, the complete magnet structure, i.e. magnets, soft iron pole piece and intermediate shims are preferably encapsulated to prevent contact between the cooling fluid and the magnets. For example, they may be contained in housing, especially a water-proof housing such as a stainless steel housing. The assembly of the new adjustable magnet structure within a target tube does not carry the risk of damaging any protective coating on the or each magnet forming the magnetically active element, which could otherwise lead to corrosion. Fine-tuning can be performed while the magnet structure remains in its waterproof housing, so all risk of water attack can be excluded.

To aid deflection, measures may be taken to reduce the mechanical rigidity of the magnetically active element. This may be achieved by, for example, using segmented components connected together as separate parts and able to move relative to each other. In the alternative or in addition, mechanical strength may be decreased by providing wrinkle zones or indentations/incisions into the magnets forming the array 1.

In this invention when applied to a rotating cylindrical target tube, optimal cooling of the inner target surface is achieved.

The cooling water in each embodiment is preferably forced close to the target tube edge and optimal heat transfer is obtained. Because of the relatively narrow spacing between the housing and the backing or target material, laminar flow may become the main coolant flow regime. This is not ideal for optimum heat transfer and dedicated topographical features on at least one of the housing or support structure may be applied and adapted to generate turbulence in the flow of cooling water over or close to the magnetically active element.

## Claims

1. A cylindrical sputtering magnetron arrangement comprising a cylindrical target (4), a magnetic field generator adjacent to said target, and a supporting structure (20) with a central supporting and water conducting tube(2), wherein said magnetic field generator includes a magnetically active element (1),
• **characterised in that**
the arrangement further comprises an adjusting means (21,22,23,24,25) for deforming or deflecting locally said magnetically active element (1) so as to alter the position of at least a portion of said magnetic field generator with respect to said target (4), said magnetically active element being hermetically sealed in a housing (3), said housing (3) being waterproof and the waterproof integrity being maintained during and after a said deformation or deflection of said magnetically active element, and the arrangement further **characterised in that** compressive or tensile forces applied by said adjustment means between the magnet housing (3) and the supporting structure (20) are translated to the local deformation or deflection of the magnet housing (3) and consequently the magnetically active element (1), while the supporting structure (20) remains substantially unchanged.

2. An arrangement according to claim 1, wherein said deformation or deflection is plastic or elastic.

3. An arrangement according to either one of claims 1 and 2, wherein said adjusting means (21,22,23,24,25) comprises a series of force activating devices spaced apart along a separation line between a support structure (20) and said magnetically active element (1), said deformation or deflection comprising relative movement between said support structure and said magnetically active element in the region of one or more of said force activating devices.

4. An arrangement according to claim 3, wherein a said force activating device applies said deformation or deflection by mechanical application of a localized force, to one or more predetermined portions of said magnetically active element.

5. An arrangement according to either one of claims 3 and 4, wherein a plurality of said force activating devices are used in combination to produce a predetermined deflection or deformation of said magnetically active element.

6. An arrangement according to any one of claims 3 to 5, wherein a said force activating device comprises a pair of tuning members (21,22) each defining a track-way, said track-ways running in different directions or planes to each other and yet guiding a common displacement element (23), so that movement of said displacement element in at least one direction along said track-ways causes relative movement between said tuning members in such a manner that a said tuning member is displaced away from the other said tuning member, said relative movement between said tuning members being used to perform said deflection or deformation of said magnetically active element.

7. An arrangement according to claim 6, wherein a first said tuning member is restricted in its degrees of freedom by the other said tuning member, such that it can only move away from or towards said second tuning member in one plane which is the plane of application of a deflection or deformation force by said first tuning member to said magnetically active element.

8. An arrangement according to either one of claims 6 and 7, wherein said adjusting means further comprises an adjusting device (24) adapted to move said displacement element (23) along said track-ways.

9. An arrangement according to claim 8, said adjusting device comprising a threaded adjuster (24) which passes through a clearance hole along the longitudinal axis of a said tuning member and which is preferably captive, said displacement member (23) including a threaded hole therethrough, through which said threaded adjuster is passed such that rotation of said adjuster (24) causes translation of said displacement member (23) along said track-ways and thereby converts said rotation into relative displacement between said turning members (21,22).

10. An arrangement according to any one of claims 6 to 9, wherein said adjusting means further comprises means for providing feedback of the amount of said deformation or deflection applied to said magnetically active element.

11. An arrangement according to claim 9, said adjusting means being adapted to provide fire adjustment of a gap between said magnetic field generator and said target, wherein a turn of said threaded adjuster (24) over 90° causes relative displacement of said tuning members (21,22) of 20 µm.

12. An arrangement according to either one previous claim, at least one of said housing (3) or a support structure (20) including one or more topographical features for conducting a flow of cooling water over at least a portion of said target and for generating a turbulence in said flow.

13. An arrangement according to any preceding claim, wherein said magnetic field generator is adapted to move in relation to said target (4).

14. An arrangement according to any preceding claim, wherein said deformation or deflection is restricted to one or more portions of said magnetically active element, a further portion of said magnetically active clement being positionally fixed or adjustable by means of a substantially independent adjusting means (21,22,23,24,25).

15. An arrangement according to any preceding claim, wherein said magnetically active element (1) includes at least one feature of shape or configuration adapted to reduce rigidity or mechanical strength of said magnetically active element, said at least one feature of shape or configuration being a segmentation, indentation, incision or a wrinkle zone.

16. A method of controlling a cylindrical sputtering magnetron, comprising the steps of: providing a cylindrical sputtering magnetron arrangement according to any one of the preceding claims; and adjusting the position of at least a portion of said magnetic field generator with respect to said target (4) by deforming or deflecting locally said magnetically active element.

17. A method according to claim 16, including the step of deforming or deflecting said magnetically active element so as to vary at least one of the magnetic field strength and the induction of a plasma racetrack across an eroding surface of said target (4).

18. A method according to either one of claims 16 and 17, wherein the step of deforming or deflecting locally said magnetically active element is effected by moving one tuning element (21,22) which is rigidly fixed to said magnetically active element in relation to another tuning member (21,22) which is rigidly fixed to a support structure (20) of said magnetic field generator.

19. A method according to claim 18, wherein the step of moving one tuning member in relation to the other tuning member is effected by moving a displacement element (23) simultaneously along a track-way of each said tuning member.

20. A method according to claim 19, wherein the step of moving said displacement element is effected by means of a lead screw arrangement (24).

21. A method according to any one of claims 16 to 20, wherein the step of adjusting the position of at least a portion of said magnetic field generator with respect to said target (4) is for the purpose of tuning a plasma racetrack generated across the surface of said target or for tuning the deposition of a film from said target on to a substrate.

## Patentansprüche

1. Zylindrische Sputtermagnetronanordnung, umfassend ein zylindrisches Target (4), einen Magnetfeldgenerator neben dem Target, und eine Trägerstruktur (20), die mit einer zentralen stützenden und Wasser führenden Röhre (2) versehen ist, wobei der Magnetfeldgenerator ein magnetisch aktives Element (1) enthält,
**dadurch gekennzeichnet, dass**
die Anordnung des Weiteren ein Einstellmittel (21, 22, 23, 24, 25) zum lokalen Verformen oder Ablenken des magnetisch aktiven Elements (1) umfasst, so dass die Position von mindestens einem Abschnitt des Magnetfeldgenerators in Bezug auf das Target (4) verändert wird, wobei das magnetisch aktive Element in einem Gehäuse (3) hermetisch abgedichtet ist, wobei das Gehäuse (3) wasserfest ist und die wasserfeste Integrität während und nach der Verformung oder Ablenkung des magnetisch aktiven Elements aufrecht erhalten wird, und die Anordnung des Weiteren **dadurch gekennzeichnet ist, dass** Druck- oder Zugkräfte, die von dem Einstellmittel zwischen dem Magnetgehäuse (3) und der Trägerstruktur (20) ausgeübt werden, in die lokale Verformung und Ablenkung des Magnetgehäuses (3) und folglich des magnetisch aktiven Elements (1) umgesetzt werden, während die Trägerstruktur (20) im Wesentlichen unverändert bleibt.

2. Anordnung nach Anspruch 1, wobei die Verformung oder Ablenkung plastisch oder elastisch ist.

3. Anordnung nach einem der Ansprüche 1 und 2, wobei das Einstellmittel (21, 22, 23, 24, 25) eine Reihe von Kraft aktivierenden Vorrichtungen umfasst, die entlang einer Trennungslinie zwischen einer Trägerstruktur (20) und dem magnetisch aktiven Element (1) in Abständen angeordnet sind, wobei die Verformung oder Ablenkung eine relative Bewegung zwischen der Trägerstruktur und dem magnetisch aktiven Element im Bereich einer oder mehrerer der Kraft aktivierenden Vorrichtungen umfasst.

4. Anordnung nach Anspruch 3, wobei eine Kraft aktivierende Vorrichtung die Verformung oder Ablenkung durch mechanische Anwendung einer örtlichen Kraft an einem oder mehreren vorbestimmten Abschnitten des magnetisch aktiven Elements bewirkt.

5. Anordnung nach einem der Ansprüche 3 und 4, wobei mehrere der Kraft aktivierenden Vorrichtungen in Kombination verwendet werden, um eine vorbestimmte Verformung oder Ablenkung des magnetisch aktiven Elements zu erzeugen.

6. Anordnung nach einem der Ansprüche 3 bis 5, wobei eine Kraft aktivierende Vorrichtung zwei Abstimmelemente (21, 22) umfasst, von welchen jedes eine Spur definiert, wobei die Spuren in verschiedenen Richtungen oder Ebenen zueinander verlaufen und dennoch ein gemeinsames Versatzelement (23) führen, so dass eine Bewegung des Versatzelements in mindestens eine Richtung entlang den Spuren eine relative Bewegung zwischen den Abstimmelementen in derartiger Weise bewirkt, dass ein Abstimmelement von dem anderen Abstimmelement weg geschoben wird, wobei die relative Bewegung zwischen den Abstimmelementen zur Durchführung der Verformung oder Ablenkung des magnetisch aktiven Elements verwendet wird.

7. Anordnung nach Anspruch 6, wobei ein erstes Abstimmelement in seinem Freiheitsgrad durch das andere Abstimmelement eingeschränkt ist, so dass es sich nur in einer Ebene von dem zweiten Abstimmelement weg und zu diesem hin bewegen kann, die die Ebene der Anwendung einer Verformungs- oder Ablenkungskraft durch das erste Abstimmelement zu dem magnetisch aktiven Element ist.

8. Anordnung nach einem der Ansprüche 6 und 7, wobei das Einstellmittel des Weiteren eine Einstellvorrichtung (24) umfasst, die dazu ausgebildet ist, das Versatzelement (23) entlang den Spuren zu bewegen.

9. Anordnung nach Anspruch 8, wobei die Einstellvorrichtung ein gewindeförmiges Einstellelement (24) umfasst, das durch ein Durchgangsloch entlang der Längsachse des Abstimmelements verläuft und das vorzugsweise unverlierbar ist, wobei das Versatzelement (23) eine Gewindeöffnung enthält, durch die das gewindeförmige Einstellelement hindurch geht, so dass eine Drehung des Einstellelements (24) eine Verschiebung des Versatzelements (23) entlang den Spuren bewirkt und somit die Drehung in eine relative Verschiebung zwischen den Abstimmelementen (21, 22) umsetzt.

10. Anordnung nach einem der Ansprüche 6 bis 9, wobei das Einstellmittel des Weiteren Mittel zum Bereitstellen einer Rückmeldung des Ausmaßes der Verformung oder Ablenkung umfasst, das auf das magnetisch aktive Element ausgeübt wird.

11. Anordnung nach Anspruch 9, wobei das Einstellmittel dazu ausgebildet ist, eine Feineinstellung eines Spalts zwischen dem Magnetfeldgenerator und dem Target vorzunehmen, wobei eine Drehung des gewindeförmigen Einstellelements (24) um 90° eine relative Verschiebung der Abstimmelemente (21, 22) von 20 µm bewirkt.

12. Anordnung nach einem der vorangehenden Ansprüche, wobei mindestens eines von dem Gehäuse (3) oder einer Trägerstruktur (20) ein oder mehrere topografische Merkmale enthält, um einen Strom von Kühlwasser über mindestens einen Abschnitt des Targets zu leiten, und um einen Wirbel in dem Strom zu erzeugen.

13. Anordnung nach einem der vorangehenden Ansprüche, wobei der Magnetfeldgenerator dazu ausgebildet ist, sich in Bezug auf das Target (4) zu bewegen.

14. Anordnung nach einem der vorangehenden Ansprüche, wobei die Verformung oder Ablenkung auf einen oder mehrere Abschnitte des magnetisch aktiven Elements begrenzt ist, wobei ein weiterer Abschnitt des magnetisch aktiven Elements in seiner Position unveränderlich oder mit Hilfe eines im Wesentlichen unabhängigen Einstellmittels (21, 22, 23, 24, 25) einstellbar ist.

15. Anordnung nach einem der vorangehenden Ansprüche, wobei das magnetisch aktive Element (1) mindestens ein Merkmal oder eine Form oder eine Konfiguration enthält, die dazu ausgebildet ist, die Steifheit oder mechanische Festigkeit des magnetisch aktiven Elements zu verringern, wobei mindestens ein Form- oder Konfigurationsmerkmal eine Segmentierung, eine Einbuchtung, ein Einschnitt oder eine Furchenzone ist.

16. Verfahren zum Steuern eines zylindrischen Sputtermagnetrons, umfassend die folgenden Schritte: Bereitstellen einer zylindrischen Sputtermagnetronanordnung nach einem der vorangehenden Ansprüche; und Einstellen der Position mindestens eines Abschnitts des Magnetfeldgenerators im Bezug auf das Target (4) durch lokales Verformen oder Ablenken des magnetisch aktiven Elements.

17. Verfahren nach Anspruch 16, enthaltend den Schritt des Verformens oder Ablenkens des magnetisch aktiven Elements, so dass mindestens eines von der Magnetfeldstärke und der Induktion eines Plasma-Erosionsgrabens über eine erodierende Oberfläche des Targets (4) variiert wird.

18. Verfahren nach einem der Ansprüche 16 und 17, wobei der Schritt des lokalen Verformens oder Ablenkens des magnetisch aktiven Elements durch Bewegen eines Abstimmelements (21, 22), das starr an dem magnetisch aktiven Element befestigt ist, im Verhältnis zu einem anderen Abstimmelement (21, 22) ausgeführt wird, das starr an einer Trägerstruktur (20) des Magnetfeldgenerators befestigt ist.

19. Verfahren nach Anspruch 18, wobei der Schritt zum Bewegen eines Abstimmelements im Verhältnis zu dem anderen Abstimmelement durch simultanes Bewegen eines Versatzelements (23) entlang einer Spur jedes Abstimmelements ausgeführt wird.

20. Verfahren nach Anspruch 19, wobei der Schritt des Bewegens des Versatzelements mit Hilfe einer Leitspindelanordnung (24) ausgeführt wird.

21. Verfahren nach einem der Ansprüche 16 bis 20, wobei der Schritt des Einstellens der Position mindestens eines Abschnitts des Magnetfeldgenerators in Bezug auf das Target (4) dem Zweck der Abstimmung eines Plasma-Erosionsgrabens dient, der über die Oberfläche des Targets erzeugt wird, oder zum Abstimmen der Abscheidung eines Films von dem Target auf ein Substrat.

## Revendications

1. Agencement de magnétron de pulvérisation cylindrique comprenant une cible cylindrique (4), un générateur de champ magnétique adjacent à ladite cible, et une structure de support (20) pourvu d'un tube de support central et conducteur d'eau (2), dans lequel ledit générateur de champ magnétique inclut un élément magnétiquement actif (1),
**caractérisé en ce que**,
l'agencement comprend en outre un moyen de réglage (21, 22, 23, 24, 25) pour déformer ou dévier localement ledit élément magnétiquement actif (1) de façon à modifier la position d'au moins une partie dudit générateur de champ magnétique par rapport à ladite cible (4), ledit élément magnétiquement actif étant hermétiquement scellé dans un logement (3), ledit logement (3) étant étanche et l'intégrité de l'étanchéité étant maintenue pendant et après une dite déformation ou déviation dudit élément magnétiquement actif, et l'agencement étant en outre **caractérisé en ce que** des forces de compression ou de traction appliquées par ledit moyen de réglage entre le logement d'aimant (3) et la structure de support (20) sont transformées en déformation ou déviation locale du logement d'aimant (3) et par conséquent de l'élément magnétiquement actif (1), tandis que la structure de support (20) reste sensiblement inchangée.

2. Agencement selon la revendication 1, dans lequel ladite déformation ou déviation est plastique ou élastique.

3. Agencement selon l'une ou l'autre des revendications 1 et 2, dans lequel ledit moyen de réglage (21, 22, 23, 24, 25) comprend une série de dispositifs d'activation de force espacés le long d'une ligne de séparation entre une structure de support (20) et ledit élément magnétiquement actif (1), ladite déformation ou déviation comprenant un mouvement relatif entre ladite structure de support et ledit élément magnétiquement actif dans la région d'un ou plusieurs desdits dispositifs d'activation de force.

4. Agencement selon la revendication 3, dans lequel un dit dispositif d'activation de force applique ladite déformation ou déviation par une application mécanique d'une force localisée, à une ou plusieurs parties prédéterminées dudit élément magnétiquement actif.

5. Agencement selon l'une des revendications 3 et 4, dans lequel une pluralité de dits dispositifs d'activation de force sont utilisés en combinaison pour produire un déviation ou une déformation prédéterminée dudit élément magnétiquement actif.

6. Agencement selon l'une quelconque des revendications 3 à 5, dans lequel un dit dispositif d'activation de force comprend un couple d'éléments d'accord (21, 22) chacun définissant un cheminement, lesdits cheminements courant dans des directions ou des plans différents les uns des autres et guidant encore un élément de déplacement commun (23), de sorte qu'un mouvement dudit élément de déplacement dans au moins une direction le long desdits cheminements provoque un mouvement relatif entre lesdits éléments d'accord de sorte qu'un dit élément d'accord est écarté de l'autre dit élément d'accord, ledit mouvement relatif entre lesdits éléments d'accord étant utilisé pour effectuer ladite déviation ou déformation dudit élément magnétiquement actif.

7. Agencement selon la revendication 6, dans lequel un premier dit élément d'accord est limité dans ses degrés de liberté par l'autre dit élément d'accord, de sorte qu'il peut seulement s'éloigner ou se rapprocher dudit second élément d'accord dans un plan particulier qui est le plan d'application d'une force de déviation ou de déformation par ledit premier élément d'accord audit élément magnétiquement actif.

8. Agencement selon l'une ou l'autre des revendications 6 et 7, dans lequel ledit moyen de réglage comprend en outre un dispositif de réglage (24) conçu pour déplacer ledit élément de déplacement (23) le long desdits cheminements.

9. Agencement selon la revendication 8, ledit dispositif de réglage comprenant un régleur fileté (24) qui passe à travers un trou de dégagement le long de l'axe longitudinal d'un dit élément de réglage et qui est de préférence captif, ledit élément de déplacement (23) incluant un trou fileté à travers ce dernier, à travers lequel ledit régleur fileté est passé de sorte que la rotation dudit régleur (24) provoque une translation dudit élément de déplacement (23) le long desdits cheminements et transforme de ce fait ladite rotation en déplacement relatif entre lesdits éléments d'accord (21, 22).

10. Agencement selon l'une quelconque des revendications 6 à 9, dans lequel ledit moyen de réglage comprend en outre un moyen pour fournir une rétroaction de la quantité de ladite déformation ou déviation appliquée audit élément magnétiquement actif.

11. Agencement selon la revendication 9, ledit moyen de réglage étant conçu pour fournir un réglage fin d'un espacement entre ledit générateur de champ magnétique et ladite cible, dans lequel un tour dudit régleur fileté (24) de 90° provoque un déplacement relatif desdits éléments d'accord (21, 22) de 20 µm.

12. Agencement selon l'une ou l'autre des revendications précédentes, au moins un dudit logement (3) ou d'une structure de support (20) incluant une ou plusieurs particularités topographiques pour conduire un flux d'eau de refroidissement sur au moins une partie de ladite cible et pour produire une turbulence dans ledit flux.

13. Agencement selon l'une quelconque des revendications précédentes, dans lequel ledit générateur de champ magnétique est conçu pour se déplacer par rapport à ladite cible (4).

14. Agencement selon l'une quelconque des revendications précédentes, dans lequel ladite déformation ou déviation est limitée à une ou plusieurs parties dudit élément magnétiquement actif, une partie supplémentaire dudit élément magnétiquement actif étant fixée de manière positionnelle ou réglable à l'aide d'un moyen de réglage sensiblement indépendant (21, 22, 23, 24, 25).

15. Agencement selon l'une quelconque des revendications précédentes, dans lequel ledit élément magnétiquement actif (1) inclut au moins une particularité de forme ou de configuration conçue pour réduire la rigidité ou la résistance mécanique dudit élément magnétiquement actif, ladite au moins une particularité de forme ou de configuration étant une segmentation, une encoche, une incision ou une zone de pli.

16. Procédé de commande d'un magnétron de pulvérisation cylindrique, comprenant les étapes de : fourniture d'un agencement de magnétron de pulvérisation cylindrique selon l'une quelconque des revendications précédentes ; et réglage de la position d'au moins une partie dudit générateur de champ magnétique par rapport à ladite cible (4) en déformant ou en déviant localement ledit élément magnétiquement actif.

17. Procédé selon la revendication 16, incluant l'étape de déformation ou de déviation dudit élément magnétiquement actif de façon à faire varier au moins l'une de l'intensité de champ magnétique et de l'induction d'une piste de plasma d'un bout à l'autre d'une surface d'érosion de ladite cible (4).

18. Procédé selon l'une ou l'autre des revendications 16 et 17, dans lequel l'étape de déformation ou de déviation localement dudit élément magnétiquement actif est effectuée en faisant mouvoir un élément d'accord (21, 22) qui est fixé de manière rigide audit élément magnétiquement actif par rapport à un autre élément d'accord (21, 22) qui est fixé de manière rigide à une structure de support (20) dudit générateur de champ magnétique.

19. Procédé selon la revendication 18, dans lequel l'étape de déplacement d'un élément d'accord par rapport à l'autre élément d'accord est effectuée en faisant mouvoir un élément de déplacement (23) simultanément le long d'un cheminement de chaque dit élément d'accord.

20. Procédé selon la revendication 19, dans lequel l'étape de mouvement dudit élément de déplacement est effectué au moyen d'un agencement de vis-mère (24).

21. Procédé selon l'une quelconque des revendications 16 à 20, dans lequel l'étape de réglage de la position d'au moins une partie dudit générateur de champ magnétique par rapport à ladite cible (4) sert au but d'accorder une piste de plasma produite d'un bout à l'autre de la surface de ladite cible ou pour accorder le dépôt d'un film provenant de ladite cible sur un substrat.
